# EUROPEAN PATENT APPLICATION

(11) **EP 1 416 404 A2**
(43) Date of publication of application: **06.05.2004**
(21) Application number: 03396100.4
(22) Date of filing: 30.10.2003
(51) Int. Cl.: G06F 17/50

(54) **Effective implementation of Open Building**

(30) Priority: 31.10.2002 FI 20021940; 31.10.2002 FI 20021941
(71) Applicant: Hartela Oy, 20101 Turku (FI)
(72) Inventor: Hartela, Heikki, 20100 Turku (FI); Tiula, Niko, 00100 Helsinki (FI)
(74) Representative: Nordin, Leif Göran

(57) **Abstract**

The invention relates to a novel method of open building and means for implementing this method. According to the invention, a support (10) for a structural unit to be designed and an interior equipment (34, 36, 38, 39, 44, 46, 50, 52) contained therein are designed separately from each other. The room spaces are selected from a number of ready-to-use room space solutions (14, 16, 18, 20, 22, 24, 26, 33, 40), which are placed on a layout of the support (10). If necessary, the measurement data of the room space solutions (14, 16, 18, 20, 22, 24, 26, 33, 40) is changed for adapting the same to the support (10) of a building.

## Description

### TECHNICAL FIELD OF THE INVENTION

The invention relates to systems, methods, and a computer software product as set forth in the preambles of the annexed independent claims. Specifically, the invention relates to a novel way of designing and constructing interior spaces of a building, as well as means for implementing this novel method.

### PRIOR ART

One of the problems in traditional construction work is the difficulty of creating individual solutions at a reasonable price. Open building refers to the allocation of authority to several disciplines regarding various stages of construction. For example, in the construction of apartments or business premises, it is the constructor who makes decisions regarding basic building structures, such as exterior walls and other load-bearing structures. The end user, such as a home buyer, will be given at least a certain degree of freedom in planning, for example, locations and surface materials for partition walls. However, the free rein allowed for the end user regarding for example locations and dimensions or selection of materials for fixtures or partition walls, often results in a long and difficult planning process. The constructor will be forced to make a multitude of changes even in the middle of a building process, regarding for example expensive and awkward piping, electrical, and other solutions. Quite often the end user has to suffer the consequences of their own amateurish misjudgments regarding, for example, selection of colors for furnishing materials. Highly diverse spatial solutions in one and the same building project also incur substantial extra costs over traditional construction, as the accessories and materials must be obtained and contracting carried out in small portions. Even in open building, for the above reasons, among others, the end user's options are typically limited to a few predesigned model solutions. Traditionally, for example the locations of water points and drains are preplanned in such a way that the relocation of a water outlet or a toilet is virtually impossible.

Another problem in traditional ways of construction engineering is the amount of manual labor required by design methods. For example, the resizing of a bathroom in one direction and inclusion of extra cabinets in finished bathroom plans require a great deal of calculation both in terms of material quantities and different structural solutions.

### SUMMARY OF THE INVENTION AND ITS PREFERRED EMBODIMENTS

It is an objective of the present invention to provide such a system and a method and a computer software product, which are capable of minimizing the above-mentioned problems of the prior art.

A particular object is to provide a more efficient and convenient way of erecting individual buildings, such as apartments or business premises, wherein interior solutions desired by the end user can be more fully appreciated while holding on to the professional skill of a constructor in terms of engineering a successful and durable building.

The foregoing drawbacks can be eliminated or mitigated and the above-defined objectives accomplished by a system, a method and a computer software product of the invention, which are characterized by what is defined in the characterizing parts of the enclosed independent claims.

The exemplary applications and benefits mentioned in this specification are intended to apply, where appropriate, equally to every system of the invention, all methods of the invention, as well as to computer software products of the invention, even if this is not always specifically pointed out.

In this specification, the term electronic data group is used in reference to one or more databases, portions of a database, a file, a portion of a file, or to some other equivalent means, in which information can be stored in electronic mode.

Means for feeding, maintaining or deleting a data group or information contained therein include typically, as known in the prior art, computers, servers or terminals and communication links therebetween. Typically, said means also comprise various computer software systems and programs, the running of which is used, for example, to execute said feeding, maintaining or deleting of information. The means comprise typically also a user interface, by means of which operation of the system is controlled by a user. The user interface is typically electronic and implemented in a software mode, controlled for example by means of a mouse or the like on computer screen. In this specification, the term data structure is used in reference to a structure, appropriate for each given purpose, for displaying information, for example to a cad-program file containing a building layout, or to a room space solution of the invention, which is implemented for example as an object-oriented GDL object. In this specification, the term portable communication device is used, for example, in reference to a portable computer, a mobile telephone or a PDA device (Personal Digital Assistant).

The structural unit to be designed refers to any building or an element thereof or to a group of several buildings or building elements, designed or constructed according to the invention. The support of a structural unit comprises at least some of the elements necessary to be included in the structural unit, including for example foundations, load-bearing structures, roof structures, parts of a facade, risers as well as staircases involved in construction engineering. The interior equipment of a structural unit comprises those elements of a building, regarding which the end users of a building, such as occupants of an apartment, have conflicting demands and desires. Thus, the interior equipment includes typically partition walls, separating doors, furniture and fixtures in a apartment, systems of construction engineering as well as surface materials inside a apartment. The interior equipment may also include parts of a facade. The measurement data for a support is used in reference to the location and size of structures included in the support, i.e., for example, a layout, along with measurements, for the support of a building. In this specification the term measurement data for a room space or a section thereof is used in reference to information comprising the external dimensions of a room space or a section thereof. The measurement data for an interior equipment comprises for example location information for elements contained in a room space, such as the size and location of furniture in a room or the locations and sizes of partition walls in an apartment, the places and sizes of doors, the places of electrical outlets, the locations of ventilation holes, the location of a certain surface material, the size of tiles, the width of panels, etc.

A typical design system of the invention for room spaces comprises an electronic data group, as well as means for maintaining and updating the electronic data group. In addition, the system comprises
- at least one data structure representing a support for a structural unit to be designed and comprising measurement data for at least the support, and
- at least one data structure representing a room space or a section thereof and comprising measurement data for at least the room space or the section thereof,
which data structures are at least partially maintainable in the electronic data group.

A typical data structure representing a support is a layout, along with its measurements, for the support of a structural unit. A typical data structure representing a room space or a section thereof is an object-oriented or otherwise implemented data structure, which is adapted to represent for example a bathroom or kitchenette, such that the external dimensions of it constitute a part of the data structure. A typical system of the invention further comprises means for placing a data structure representing a room space or a section thereof in a desired location within a data structure representing the support of a structural unit to be designed. In addition, a typical system comprises means for changing in at least one direction the measurement data of a data structure representing a room space or a section thereof. In other words, the length of a data structure representing for example a bathroom can be adjusted as desired according to the invention. In a typical system of the invention, all this can be executed in one user interface for example in such a way that the layout of an apartment to be designed is displayed on a computer screen and a desired predesigned room space solution is chosen from the database. For example, after a desired type of bathroom has been selected, it can be conveyed by means of a mouse to a desired location on the apartment layout and resized as appropriate.

A typical method of the invention used in construction engineering comprises maintaining in an at least partially electronic data group a data structure representing a support of a structural unit to be designed and data structures representing various room spaces or sections of a room space connectable with the support. The method is carried out by using an electronic user interface for executing the following steps of:
- maintaining processable a data structure, such as an apartment layout, representing a support of a structural unit to be designed,
- selecting one or more data structures, which may have the appearance of a layout representing for example a bathroom with its fixtures and which represent a room space or a section thereof, for example a bathroom
- locating the selected one or more data structures representing a room space or a section thereof within the above-mentioned data structure representing a support, for example by dragging with a mouse, and
- adapting the selected one or more data structures representing a room space or a section thereof to match the support of a structural unit to be designed in terms of the sizing thereof.
Said adaptation can be performed for example by grabbing with a mouse on the edge of a data structure representing a bathroom and by pulling the same to a desired size.

The invention can also be implemented in the form of a computer software product, the discussed computer software product comprising program code elements necessary for executing the method steps of the invention as the program is run on a computer. According to the invention, the computer software product can be stored in some sort of storage means or it may be constituted by a group of electronic data traveling in some means of communication.

A typical building method for room spaces of the invention comprises the following steps of
a) designing a support for a structural unit and preparing therefrom a layout for the structural unit,
b) constructing the support of a building designed in step a),
c) designing at least part of an interior equipment for the structural unit designed in step a) by selecting the room spaces from a number of finished room space solutions consisting of a single room space or a section thereof and comprising measurement data at least for the room space or a section thereof, and
d) constructing at least part of the interior equipment for the building's room spaces according to the design of step c).
The room space solution consisting of a room space or a section thereof being finished refers to the fact that such a room space or a section thereof has been designed entirely ready even before designing the support of a building or at least separately from this designing of a support. According to the invention, the room space solutions are placed in step c) on a layout designed in step a). According to the invention, the measurement data for room space solutions is then changed, if necessary, for adapting the room space solutions to the support of a building.

A typical system of the invention for use in the designing of interiors for buildings comprises
- means for representing measurement data for a room space or a section thereof, i.e. for example a bathroom layout with measurements,
- means for representing a location for the materials of an interior equipment for a room space or a section thereof, i.e. for example a layout regarding bathroom furniture and fixtures, said layout being also marked for the location of various surface materials, and
- means for calculating the amount of materials for the interior equipment of a room space or a section thereof, for example in boxes marked along the edge of a layout.
According to the invention, said means for representing measurement data for a room space or a section thereof are adaptable in such a way that the measurement data is convertible as desired. For example, a paper layout for a room space can be foldable, the room space layout being then extended by unfolding more creases.

One of the most significant benefits of the invention is that it enables an efficient tailoring of "industrially" constructed apartments.

Another highly important benefit of the invention is that it facilitates architectural design of building projects and releases the designer's resources from routine work, for example for working out apartment layouts.

The invention provides a possibility even for amateurs of designing room spaces, for example for a sales agent or for a home or office buyer.

Still another very important benefit of the invention is its ability to provide for the end user a possibility of designing an individual apartment for themselves quickly, conveniently and economically. The invention makes it easier for a client to make choices regarding their own apartment and guides the choices towards technically and interiorwise sound solutions. At the same time, the invention allows for professionalism in construction methods, minimizes mistakes, and ensures high-quality construction work. The invention enables the constructor to reduce or even eliminate inconvenient and expensive alterations to presently finished plans or solutions.

A further significant benefit of the invention is that production can be standardized thereby to enable e.g. the production of certain fixtures in series for stock.

A structural unit to be designed by means of the invention, its support and/or a room space or a section thereof fitted therein can be readily used to prepare therefrom, say, a construction drawing for the project, a list for the amounts of materials needed in the project, a price estimation for implementing the project or a photo realistic perspective image of the designed space. For example, a room space or a section thereof, representing a single room and fitted in a support, can be used to make projection images thereof, for example 4 wall projections, as well as floor and ceiling projections. The system or computer program of the invention may comprise a price calculator which calculates on demand or continuously maintains the current price for a entity to be designed as well as the price of a preceding project version, as well as the difference between these prices. By monitoring these prices and the difference therebetween, the designer can conveniently observe the effect on total costs caused by alterations made by him- or herself.

In a highly preferred system or method of the invention, the data structure representing a room space or a section thereof further comprises measurement data for the interior equipment of the room space or a section thereof. Even more preferably, the system additionally comprises means for changing in at least one direction the interior equipment's measurement data of a data structure representing a room space or a section thereof. In a particularly preferred case, said means for changing the measurement data of the interior equipment are adapted to be function automatically as changes are made to the measurement data of a data structure representing a room space or a section thereof. Hence, a system is achieved which automatically updates several items of data contained in the project as a single item is changed. For example, when stretching a bathroom to an extended length, the discussed system fills in the project automatically in the stretching direction some elements contained in the project, for example tiling or cabinets.

If the system further comprises means for automatically calculating the amounts of interior equipment needed for building a room space or a section thereof represented by a data structure, the system provides conveniently, after adapting the size of a room space, for example the number of cabinets to be fitted in a bathroom or the consumption of various types of tiles.

A particularly preferred system of the invention comprises means for limiting certain measurement data. More preferably, the system is further provided with means for adding, changing or deleting said limitations. These limitations and means for controlling the same refer to the fact that such systems of the invention are smart and capable of being taught. Room space models or data structures can be readily provided with certain minimum or maximum distances for controlling the distances between certain interior equipment elements in view of laws and regulations or practicality or ergonomics. This also makes it possible to easily eliminate frequent minor design errors and shortcomings. For example, the rooms must always be left with sufficiently wide passageways, but especially if it is desirable to enable unimpeded movements for a wheelchair. For example, in front of certain or all fixtures it is possible to define a minimum distance, which must be vacant for assuring a sufficient space.

A preferred system of the invention is provided with means for creating so-called allocation zones in data structures representing a support of a structural unit. The allocation zones are intended to guide the positioning of data structures representing a room space or a section thereof to be accommodated in the support. Such allocation zones can be, for example, predesigned by an architect. This is to secure a professional handprint for example in planning the allocation of rooms. An allocation zone can be defined for example in such a way that it enables a determination of maximum sizes for a room space or a section thereof fitted in the zone. Of course, the allocation zones can be set to be designed by the actual end user.

A preferred method of the invention is executed at least in a partially wireless fashion or over the Internet or some other information network. In this case, the inventive system comprises a terminal device for the Internet or another corresponding information network and/or a portable communication device. Such a device is provided with a user interface, by way of which the selection of a data structure representing a room space or a section thereof, the sizing thereof, and the selection of interior equipment materials to be used therein are adapted to be executed. Thus, the communication between a user interface and a data group, i.e. for example a database containing various finished room space solutions, which communication is needed for operations, is transmitted for example over a wireless communication network, the internet or a corresponding information network. Naturally, a database or the like can also be physically included in the same device as the user interface. The devices used can be for example workstations, but of course, it is also possible to include the entire system in one or more portable communication devices. The use of such systems enables, for example, designing one's own apartment from one's present home or efficient comparison between various optional apartments on sale even from long distances away.

In a particularly preferred method and system of the invention, the data structure representing a room space or a section thereof comprises identification data regarding interior equipment materials for the room space or a section thereof. This refers to the fact that a data structure, representing for example a bathroom, contains certain information about every material used in the bathroom, for example the model, type, color, shape, manufacturer, dimensions and price of a material. Preferably, in some electronic data group there is maintained identification data regarding various possible materials for the interior equipment of a room space or a section thereof. Thus, the preferred system also includes means for feeding, maintaining and deleting said identification data present in a data group. If such a system is further provided with means for selecting and replacing at least some of the interior equipment materials of a data structure representing a room space or a section thereof as desired by the end user, the result will be a system which maintains a record of all used material choices. Such a system can be readily adapted to produce listings of the amounts of materials required by a project or an element thereof and the price of the project. If the system comprises, regarding each material used, also information about what its appearance is like in reality, it is possible to output photo realistic images of a project to be designed on a computer screen or paper. Programmatically implementable is also a virtual passage within a three-dimensional project. These facilities make it possible for a client to survey e.g. the results of a design project and to work on the price of an apartment in a convenient and tangible manner through the level of interior equipment.

According to the invention, the system may further comprise means for limiting the selection and replacement of interior equipment materials for room spaces. In this case, the system could, for example, only accept certain material combinations or, say, color palettes previously entered into the system. This would make the handprint of a professional interior decorator or architect conveniently available for each homebuyer. Certain materials would not perhaps be joinable together at all or could not, for reasons of fire safety aspects, be positioned at certain locations, for example near the electric kitchen range. At least occasionally, it should also be possible to depart from these preselected combinations.

A typical system and method of the invention utilizes ready-to-use models, representing various room space solutions, which comprise a single room space or a section thereof. Preferably, the very same room space solutions have already been used earlier in the process of engineering some other structural unit. Thus, at this stage of planning there is no need to spend any time for engineering basic solutions for room spaces. The previously applied solutions have already been tested in practice and, if mistakes have been detected, those solutions have probably already been subjected to corrections and improvements.

In a typical preferred building method of the invention, while engineering a support for a structural unit and preparing therefrom a layout for the structural unit, the support is also subjected to special engineering, such as heating, plumbing, air-conditioning, electrical and structural engineering. Respectively, in the process of engineering ready-to-use room space solutions of the invention, those are also pre-designed with special engineering for a room space or a section thereof, such as heating, plumbing, air-conditioning and electrical engineering. Then in the process of constructing the interior equipment for room spaces, said special engineering designs for the support and room space solutions can be readily integrated with each other. The invention also enables an automatic execution of said integration of special engineering designs.

Subsequently in this specification, the basic concept of the invention, i.e. the inventive design and construction method and system, is referred to by the applicant's trademark KIDE™ in combinations with various words. A data structure representing at least one room space or a section thereof is referred to by the term KIDE™ structure.

One way of describing the basic inventive concept is that the management of information needed in construction work will be facilitated thereby. A project entity, comprising one or more buildings or facilities, can be easily dealt with by means of the invention as a single information model which contains one or more data structures of the invention, i.e. KIDE™ structures. The KIDE™ structure in and of itself may contain one or more KIDE™ structures. For example, one KIDE™ structure represents a single room and that, in turn, may contain a plurality of KIDE™ structures, e.g. a cabinet. The latter, again, may be provided with several KIDE™ structures, such as cabinet doors or drawers. By means of the invention, all this can now be compiled into a single information model, whereby information can be managed in a centralized and effective fashion.

### BRIEF DESCRIPTION OF THE DRAWINGS

The invention will now be described in more detail with reference to the accompanying drawings, in which:
- Figs. 1-4: show schematically a first example about designing an apartment building floor according to the invention, depicted in four stages,
- Figs. 5-8: show schematically a second example about designing an apartment building floor according to the invention, depicted in four stages,
- Figs. 9-12: show schematically four options created from one KIDE™ structure of the invention and by changing its parameters, and
- Figs. 13-15: show schematically measurement data for one KIDE™ structure of the invention by modifying three established options.

### DETAILED DESCRIPTION OF PREFERRED EMBODIMENTS

KIDE™ thinking is based on conceptions regarding connectable spaces or sections thereof. From a single space is established a separate conceptual entity, which in itself is parametrically modifiable. A fixture housed in the space, such as a kitchen island, may also constitute a KIDE™ structure. The conception of a apartment or some other space takes shape by combining KIDE™ concepts with each other.

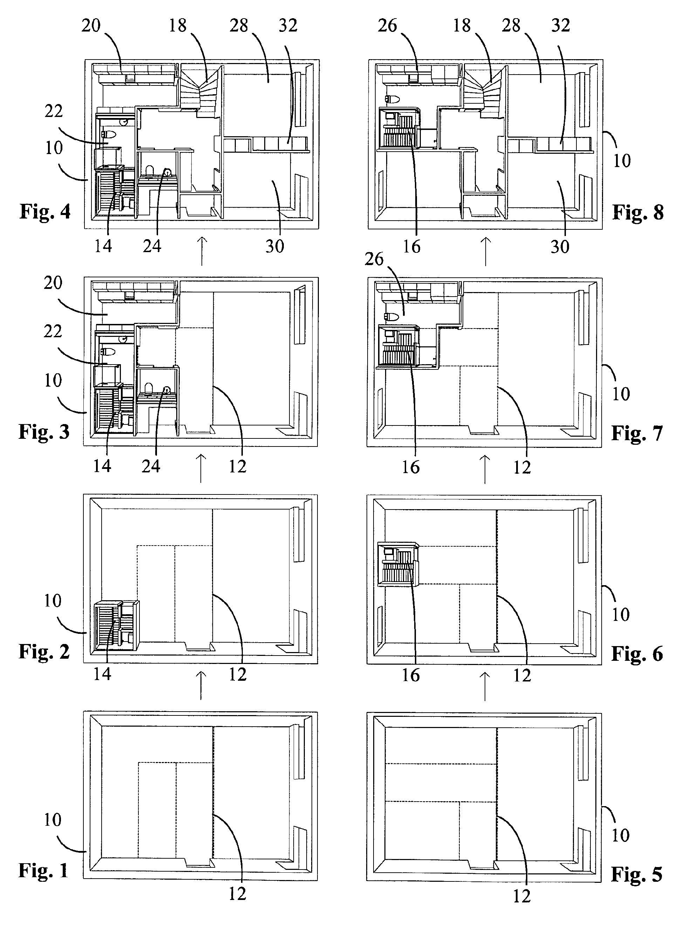

Figs. 1-4 and 5-8 illustrate two examples of how identical KIDE™ structures can be used for designing one and the same apartment with totally different space solutions. Figs. 1 and 5 depict layouts representing a floor support 10 as visible to a user for example on a computer screen. Depicted in dashed lines are limits 12 for allocation zones for guiding the user in the allocation on a layout of KIDE™ structures representing rooms. The allocation zones 12 can be either previously designed or else freely at a user's disposal. In figs. 2 and 6, the layouts are provided with KIDE™ structures 14 and 16 representing a sauna steam room. The question here is about one and the same KIDE™ structure, for which the user has selected a basic solution of his or her preference by modifying parameters of the steam room's KIDE™ structure 14. The steam room 14 is also extended in the direction of the allocation zone 12 to be slightly larger than the steam room 16. In figs. 3, 4, 7 and 8, the layouts are provided with more KIDE™ structures, such as a staircase 18 and several bathrooms. Bathrooms 20, 22, 24 and 26 are designed from one bathroom representing KIDE™ structure by stretching it to various sizes and by choosing various fixtures therefor by modifying parameters of the KIDE™ structure. Walls between bedrooms 28 and 30 and cabinets 32 are designed in a traditional way without a KIDE™ structure of the invention.

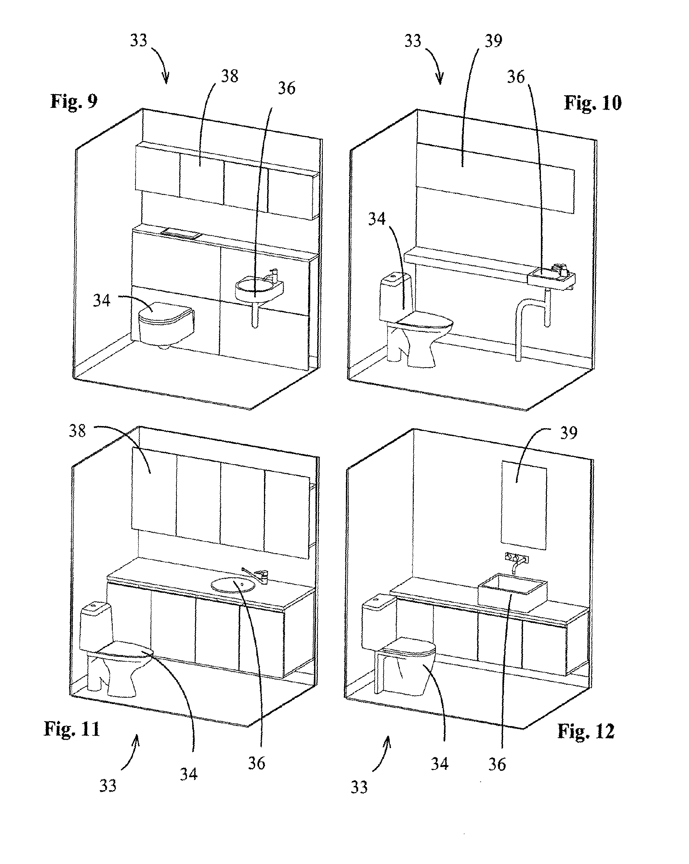

Figs. 9-12 illustrate options available from one bathroom representing KIDE™ structure by modifying its parameters the way such options are visible to a user in one preferred computer program of the invention. By modifying parameters, one is able to choose e.g. a type of fixture, a seat solution for sauna or handedness for doors. The parameters provide for a multiplicity of variations with a manageable number of various KIDE™ structures. Selection of furnishings for a room space or a section thereof can be effected in various ways. In KIDE™ structures, the arrangement of furnishings can be selectable from just a few pre-designed options or a client may design his or her room from the very beginning. Furnishings can be relocated for example in such a way that a piece chosen for relocation is first activated in a user interface for example with a mouse and then dragged with the mouse to a desired location. The model or color of a toilet seat 34, a sink 36, a cabinet 38 or a mirror 39, selected for activation, can be changed for example from a main menu in the window of a computer program of the invention.

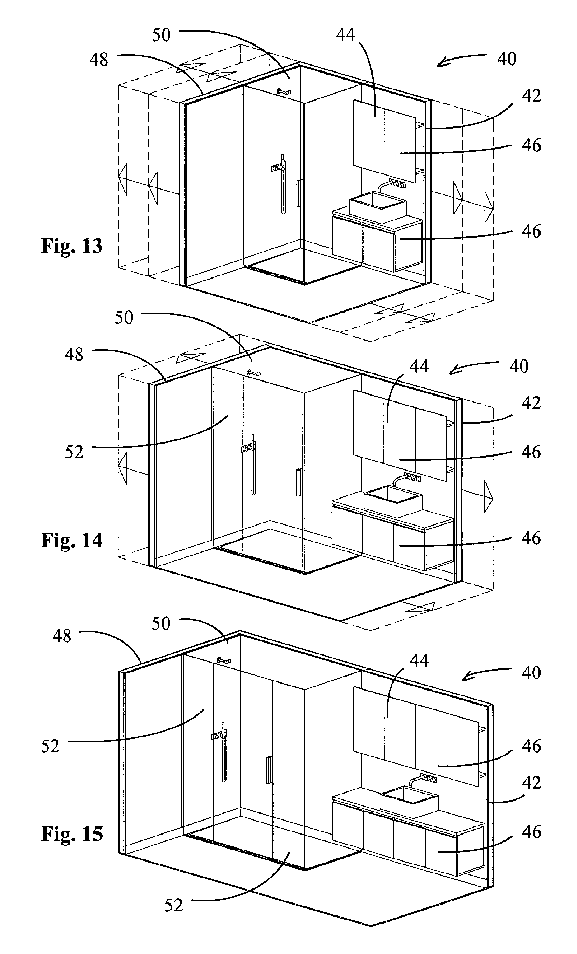

Figs. 13-15 illustrate how a bathroom representing KIDE™ structure 40 of the invention is made adaptable in terms of its size. The data structure is provided with a determination regarding what happens to the set of furnishings in the process of stretching the room. As the bathroom in fig. 13 is stretched from its right-hand side 42, it can only be stretched by certain steps, which are determined by the width of available individual units 46 of a set of cabinets 44 previously chosen for the room. The same way, in the process of stretching the room from the left-hand side 48, the length of stretching distance steps is determined by the length of extra elements 52 available for the wall of a shower cabinet 50.

Stretching the size of KIDE™ structures, selecting applied materials, and allocating KIDE™ structures on a layout drawing can each be programmed to occur in its own window or image, such as in the foregoing examples. On the other hand, various functions of the designing program can also be programmed to be executed in one and the same image.

Regarding the size thereof, KIDE™ structures are typically extensible in one direction. The extension can be limited to occur at certain intervals, e.g. in accordance with a tile spacing. The extension can also be given a determined minimum and maximum distance. Dimensions have been programmed in the designs, which fulfill directives and regulations and which can be set to limit the user's freedom of design. A single-direction extensibility of the size of room spaces facilitates the integration of separate spaces and clarifies the drafting of an apartment floor layout. A single space may also be constituted by several crystals, whereby the immobilization of one dimension makes the integration or matching particularly more convenient, for example when KIDE™ structures, involving a toilet, a shower and a sauna, jointly make up a bathroom space. If necessary, the extension may nevertheless occur in more directions than one. The permanence of one dimension also enables production of standard size fixtures for stock. The permanent dimension can be different in different applications. In an apartment building, for example, it is possible to apply a permanent dimension, which is smaller, e.g. 1540 mm, than that used in a detached house, e.g. 1840 mm. In an empty apartment floor layout, the KIDE™ structures often find a natural allocation zone, see figs. 1-8, which comprises a recommended strip having a width equal to said permanent dimension, on which the allocation of KIDE™ structures is advised. Of course, such structures can also be positioned outside the allocation zone. The allocation zone is an architect's way of designing an apartment floor layout to match the KIDE™ structural system in terms of its dimensions and arrangement of apertures.

KIDE™ interior plans are typically 3D overall plans for a space, i.e. they have not only a floor but also all wall projections and a ceiling image dimensioned. The plan may include for example a tiling instruction, such that the joint spacing is correctly planned on the floor and wall, even if the space was stretched or the tile size of one surface was changed. Also, for example electrical outlets, lighting fixtures, hooks and valves are shown in the image automatically dimensioned at correct locations. If an implemented KIDE™ structural design is found to have some item incorrectly positioned, this can be corrected for the KIDE™ structure in such a way that in subsequent implementations it will be at a right location. Thus, by means of KIDE™ structures, the plan becomes capable of learning. The same, once designed crystals and materials are typically used in all apartment projects.

The planning of an apartment is typically performed according to the invention as follows. The inventive software is at the disposal of a person who is selling an apartment and who is met by a prospective buyer. First, as shown in figs. 1-8, desired room spaces are allocated on the floor layout of the apartment. This is followed by proceeding to select materials and equipment, as shown in figs. 9-12. According to the invention, the materials are preferably selectable from a complete catalog or a so-called material matrix. The materials are highly preferably chosen to be mutually compatible for providing uniform, stylish and practical entities. For easier selection, the materials are preferably classified previously for various main groups and subdivided for style examples. Some of the materials can even be included in several groups. More new groups and style models can always be created whenever necessary, for example in keeping with fashion trends in interior decoration. When a KIDE™ structure is informed about a selected style example, all materials of the said crystal become default materials for the style. After this, the materials of individual surfaces can be changed one by one. The program automatically presents recommended alternatives picked up by the designer. For example, the alternative for an ordinary black tile can be a black granite tile, a black mosaic tile or some other color tile that fits the color scale. This makes it easier for a client to choose and stylish overall effects are "inevitably" created. Speeding up the selection process is important in terms of resources spent in selling apartments. Materials are priced in such a way in the system that a client is able see immediately the effect of his or her choice on the total price. There are preferably sufficiently large specimens of materials available for a client to form a perception about the material in actual use. The choice is also visualized photo realistically in the 3D model. In a highly preferred method of the invention, the buyer of an apartment is able to conduct the planning of his or her apartment from home over the Internet or a corresponding information network. The prospective buyer may plan or design his or her apartment even before the actual transaction.

The color and material palette is maintained on a table containing information on various materials and parameters required by the programs, indicating e.g. on which surface any one of the materials may appear. The software comprises preferably a special program, which enables a designer to store a KIDE™ structure of his or her design as a new style.

The inventive construction of buildings designed by means of KIDE™ structures is divided in two stages. The support of a building can be designed and built disregarding the inventive design of an interior equipment effected by means of KIDE™ structures. The second stage of construction does not begin until the premises are sold and the interior equipment design made with KIDE™ structures is complete. After the deal is closed and the plan is completed, the orders for surface materials are automatically obtained from a system of the invention. Provided that the actual body of a apartment is already completed, the client shall receive a ready-to-occupy apartment quickly, for example within two months of the order. First, sewer and pipe systems are typically laid in the premises, e.g. in a cast gypsum assembly floor. Then the assembly floor is allowed to dry. Technology used in the building support is desirably concentrated elsewhere from the actual floor of an apartment or other premises for providing the best possible freedom of design for the positioning of KIDE™ structures. In the next stage, partition walls are built, surfaces are finished, and the interior of the premises is equipped.

As the production process becomes smoother, the inventive mode of construction probably saves time when compared to traditional open building. The amount of waste material can be expected to decrease as a result of accurate consumption data. Savings are achieved in apartment planning costs as the room spaces are designed only once and the final design comes from the buyer of a apartment or other premises sort of free of charge.

The entire planning system of the invention, along with material palettes and all guidelines therefor, can be included in every KIDE™ structure. Thus, the entire system would be extremely mobile. Premises could be built entirely separately from designed KIDE™ structures. The execution of KIDE™ designs can be carried out in any programming language by utilizing ready-to-use design software systems and their capabilities. For example, the ArchiCad™ program and its GDL object language are appropriate for the purpose.

Premises of highly diverse types can be planned or designed by means of KIDE™ structures, for example apartments or office facilities. The invention also lends itself excellently to the planning of shop concepts, which are intended to achieve repeated and hence identifiable design solutions and whose material worlds are intended to achieve a uniform look.

It is obvious for a person skilled in the art that the invention is not limited solely to the foregoing examples but that the invention may vary within the scope defined by the enclosed claims. The dependent claims disclose a few plausible embodiments of the invention and, as such, cannot be considered to limit the scope of protection of the invention.

## Claims

1. A design system for room spaces, which comprises an electronic data group, as well as means for maintaining and updating the electronic data group, as well as additionally
- at least one data structure representing a support (10) for a structural unit to be designed and comprising measurement data for at least the support (10),
- at least one data structure representing a room space (14, 16, 18, 20, 22, 24, 26, 33, 40) or a section thereof and comprising measurement data for at least the room space or the section thereof,
said data structures being at least partially maintainable in the electronic data group,
said system further comprising means for locating the data structure representing the room space (14, 16, 18, 20, 22, 24, 26, 33, 40) or a section thereof in a desired location within the data structure representing the support (10) for a structural unit to be designed,
**characterized in that** the system further comprises means for changing, at least in one direction, the measurement data of the data structure representing the room space (14, 16, 18, 20, 22, 24, 26, 33, 40) or a section thereof.

2. A system as set forth in claim 1, **characterized in that** the data structure representing a room space or a section thereof further comprises measurement data for an interior equipment (34, 36, 38, 39, 44, 46, 50, 52) in the room space (14, 16, 18, 20, 22, 24, 26, 33, 40) or a section thereof.

3. A system as set forth in claim 2, **characterized in that** the system further comprises means for changing, at least in one direction, the measurement data for the interior equipment (34, 36, 38, 39, 44, 46, 50, 52) in the data structure representing the room space (14, 16, 18, 20, 22, 24, 26, 33, 40) or a section thereof.

4. A system as set forth in claim 3, **characterized in that** said means for changing the measurement data of the interior equipment (34, 36, 38, 39, 44, 46, 50, 52) are adapted to be automatically functioning in the process of changing the measurement data of the data structure representing the room space (14, 16, 18, 20, 22, 24, 26, 33, 40) or a section thereof.

5. A system as set forth in any of the preceding claims, **characterized in that** the system comprises means for automatically calculating the amounts of interior equipment (34, 36, 38, 39, 44, 46, 50, 52) needed for building the room space (14, 16, 18, 20, 22, 24, 26, 33, 40) or a section thereof represented by the data structure.

6. A system as set forth in any of the preceding claims, **characterized in that** the system further comprises means for limiting certain measurement data.

7. A system as set forth in claim 6, **characterized in that** it further comprises means for adding, changing or deleting measurement data limitations.

8. A system as set forth in any of the preceding claims, **characterized in that** it comprises means for creating allocation zones (12) at a desired location in the data structure representing the support (10) of the structural unit to be designed, said allocation zones (12) being arranged for controlling locating of the data structures representing the room space (14, 16, 18, 20, 22, 24, 26, 33, 40) or a section thereof according to said allocation zones (12).

9. A system as set forth in claim 8, **characterized in that** the allocation zone (12) defines limits for the changing of the measurement data of a data structure representing the room space (14, 16, 18, 20, 22, 24, 26, 33, 40) or a section thereof located therein, i.e. limits regarding in which direction or directions and to which extent the measurement data can be changed.

10. A system as set forth in any of the preceding claims, **characterized in that** it comprises a terminal device for the internet or other such information network and/or a portable communication device, having its user interface adapted to be used for executing the selection of a data structure representing the room space (14, 16, 18, 20, 22, 24, 26, 33, 40) or a section thereof, the sizing thereof, and the selection of the interior equipment materials 34, 36, 38, 39, 44, 46, 50, 52) used therein.

11. A system as set forth in claim 10, **characterized in that** communication between the user interface and the information network needed for operations is transmitted over a wireless communication network or the Internet or a corresponding information network.

12. A system as set forth in claim 10, **characterized in that** the entire system is housed in one or more portable communication devices.

13. A system as set forth in any of the preceding claims, **characterized in that** the data structure representing a room space or a section thereof further comprises identification data regarding materials for the interior equipment (34, 36, 38, 39, 44, 46, 50, 52) of the room space (14, 16, 18, 20, 22, 24, 26, 33, 40) or a section thereof, such as one or more of the following: model, type, color, shape, manufacturer, price, dimensions of a material.

14. A system as set forth in claim 13, **characterized in that** the system comprises an electronic data group, which contains identification data regarding a variety of materials for the interior equipment (34, 36, 38, 39, 44, 46, 50, 52) of the room space (14, 16, 18, 20, 22, 24, 26, 33, 40) or a section thereof, as well as means for feeding, maintaining and deleting said identification data present in the data group.

15. A system as set forth in claim 13 or 14, **characterized in that** the system further comprises means for enabling a selection and/or a replacement of at least some of the materials of the interior equipment (34, 36, 38, 39, 44, 46, 50, 52) of a data structure representing the room space (14, 16, 18, 20, 22, 24, 26, 33, 40) or a section thereof.

16. A system as set forth in claim 15, **characterized in that** the system further comprises means for limiting the selection and replacement of materials for the interior equipment (34, 36, 38, 39, 44, 46, 50, 52) in such a way that the system only accepts certain material combinations pre-entered in the system.

17. A system as set forth in any of the preceding claims, **characterized in that** the system further comprises means, which enable, regarding at least a section of the support (10) of a structural unit to be designed and/or at least a section of at least one room space (14, 16, 18, 20, 22, 24, 26, 33, 40) fitted therein, to produce at least one of the following: a structural drawing for the project, a list for the amounts of materials needed in the project, a price for implementing the project, a photo realistic perspective image.

18. A method in construction engineering, said method comprising maintaining in at least a partially electronic data group a data structure representing a support (10) of a structural unit and data structures representing various room spaces (14, 16, 18, 20, 22, 24, 26, 33, 40) or sections of a room space connectable with the support (10), **characterized in that** an electronic user interface is used for
- maintaining processable a data structure representing the support (10) of a structural unit to be designed,
- selecting one or more data structures representing the room space (14, 16, 18, 20, 22, 24, 26, 33, 40) or a section thereof,
- locating the selected one or more data structures representing the room space (14, 16, 18, 20, 22, 24, 26, 33, 40) or a section thereof within the data structure representing the support (10), and
- adapting the dimensioning of the selected one or more data structures representing the room space (14, 16, 18, 20, 22, 24, 26, 33, 40) or a section thereof to match the support (10) of the structural unit to be designed.

19. A method as set forth in claim 18, **characterized in that** further information is maintained in an electronic data group about various interior equipment materials (34, 36, 38, 39, 44, 46, 50, 52) and that an electronic user interface is used for
- selecting the desired interior equipment materials (34, 36, 38, 39, 44, 46, 50, 52) for one or more data structures representing the room space (14, 16, 18, 20, 22, 24, 26, 33, 40) or a section thereof.

20. A method as set forth in claim 19, **characterized in that** a record is also maintained automatically regarding the amounts of the interior equipment materials (34, 36, 38, 39, 44, 46, 50, 52).

21. A method as set forth in any of the preceding claims 18-20, **characterized in that** the selection of a data structure representing the room space (14, 16, 18, 20, 22, 24, 26, 33, 40) or a section thereof, its sizing, and the selection of the interior equipment materials (34, 36, 38, 39, 44, 46, 50, 52) used therein are executed with an internet terminal and/or a portable communication device, such that communication between the user interface and the data group needed for operations is transmitted over a wireless communication network or the internet or a corresponding information network.

22. A computer software product, comprising a computer program which includes program code elements adapted to execute at least the method steps of claim 18 as the program is run.

23. A building method for room spaces, comprising the following steps of
a) designing a support (10) for a structural unit and preparing therefrom a layout for the structural unit,
b) constructing the support (10) of a building designed in step a),
c) designing at least part of an interior equipment (34, 36, 38, 39, 44, 46, 50, 52) for the room spaces of the structural unit designed in step a) by selecting the room spaces from a number of ready-to-use room space solutions (14, 16, 18, 20, 22, 24, 26, 33, 40) consisting of a single room space or a section thereof and comprising measurement data at least for the room space or a section thereof,
d) constructing at least part of the interior equipment (34, 36, 38, 39, 44, 46, 50, 52) for the building's room spaces according to the design of step c),
**characterized in that** step c) comprises placing the room space solutions (14, 16, 18, 20, 22, 24, 26, 33, 40) on the layout designed in step a) and that the measurement data for the room space solutions (14, 16, 18, 20, 22, 24, 26, 33, 40) is changed, if necessary, for adapting the room space solutions to match the building support (10).

24. A method as set forth in claim 23, **characterized in that** the same finished room space solutions (14, 16, 18, 20, 22, 24, 26, 33, 40), consisting of a single room space or a section thereof, have already been used earlier in the planning of some other structural unit.

25. A method as set forth in claim 23 or 24, **characterized in that** the designing in step a) comprises also special engineering for the support (10), such as heating, plumbing, air-conditioning, electrical and structural engineering.

26. A method as set forth in any of the preceding claims 23-25, **characterized in that** the finished room spaces (14, 16, 18, 20, 22, 24, 26, 33, 40) comprise special engineering for at least a room space or a section thereof, such as heating, plumbing, air-conditioning and electrical engineering.

27. A method as set forth in claim 26, **characterized in that** step d) comprises combining together said special engineering designs of the support (10) and the room space solutions (14, 16, 18, 20, 22, 24, 26, 33, 40).

28. A system for use in the designing of interiors for buildings, comprising
- means for representing measurement data for a room space (14, 16, 18, 20, 22, 24, 26, 33, 40) or a section thereof,
- means for representing a location for the materials of an interior equipment (34, 36, 38, 39, 44, 46, 50, 52) for a room space or a section thereof,
- means for calculating the amount of materials for the interior equipment (34, 36, 38, 39, 44, 46, 50, 52) of a room space or a section thereof,
**characterized in that** said means for representing measurement data for the room space (14, 16, 18, 20, 22, 24, 26, 33, 40) or a section thereof are adaptable in such a way that the measurement data is modifiable as desired.
